(19) Europäisches Patentamt
European Patent Office
Office européen des brevets

(11) **EP 1 476 849 B1**

(12) **FASCICULE DE BREVET EUROPEEN**

(45) Date de publication et mention
de la délivrance du brevet:
**25.06.2008 Bulletin 2008/26**

(21) Numéro de dépôt: **03718862.0**

(22) Date de dépôt: **11.02.2003**

(51) Int Cl.:
*G06K 19/07* *(2006.01)*   *G06K 19/067* *(2006.01)*
*G11C 11/56* *(2006.01)*

(86) Numéro de dépôt international:
**PCT/FR2003/000443**

(87) Numéro de publication internationale:
**WO 2003/069550 (21.08.2003 Gazette 2003/34)**

(54) **TRANSPONDEUR ELECTROMAGNETIQUE A CODE PROGRAMMABLE**

ELEKTROMAGNETISCHER TRANSPONDER MIT PROGRAMMIERBAREM CODE

ELECTROMAGNETIC TRANSPONDER WITH A PROGRAMMABLE CODE

(84) Etats contractants désignés:
**AT BE BG CH CY CZ DE DK EE ES FI FR GB GR HU IE IT LI LU MC NL PT SE SI SK TR**

(30) Priorité: **11.02.2002 FR 0201642**

(43) Date de publication de la demande:
**17.11.2004 Bulletin 2004/47**

(73) Titulaire: **STMicroelectronics S.A.**
**92120 Montrouge (FR)**

(72) Inventeurs:
• **WUIDART, Luc**
**F-83910 Pourrières (FR)**

• **BARDOUILLET, Michel**
**F-13790 Rousset (FR)**

(74) Mandataire: **de Beaumont, Michel**
**Cabinet Michel de Beaumont**
**1, rue Champollion**
**38000 Grenoble (FR)**

(56) Documents cités:
**EP-A- 0 828 229      WO-A-97/05665**
**GB-A- 2 279 474      US-A- 4 231 458**
**US-A- 5 536 968**

EP 1 476 849 B1

# Description

La présente invention concerne un transpondeur électromagnétique, c'est-à-dire un émetteur-récepteur (le plus souvent mobile) susceptible d'être interrogé, sans contact et sans fil, par une unité (généralement fixe), dite borne de lecture et/ou écriture. Généralement, les transpondeurs extraient l'alimentation nécessaire aux circuits électroniques qu'ils comportent d'un champ haute fréquence rayonné par une antenne de la borne de lecture et d'écriture. Il existe des transpondeurs à lecture seule, c'est-à-dire propres à fonctionner avec une borne se contentant de lire des données du transpondeur, et des transpondeurs à lecture-écriture qui contiennent des données qui peuvent être modifiées par la borne.

Les systèmes utilisant des transpondeurs électromagnétiques sont basés sur l'emploi de circuits oscillants comprenant un enroulement formant antenne, côté transpondeur et côté borne de lecture-écriture. Ces circuits sont destinés à être couplés par champ magnétique proche lorsque le transpondeur entre dans le champ de la borne de lecture-écriture.

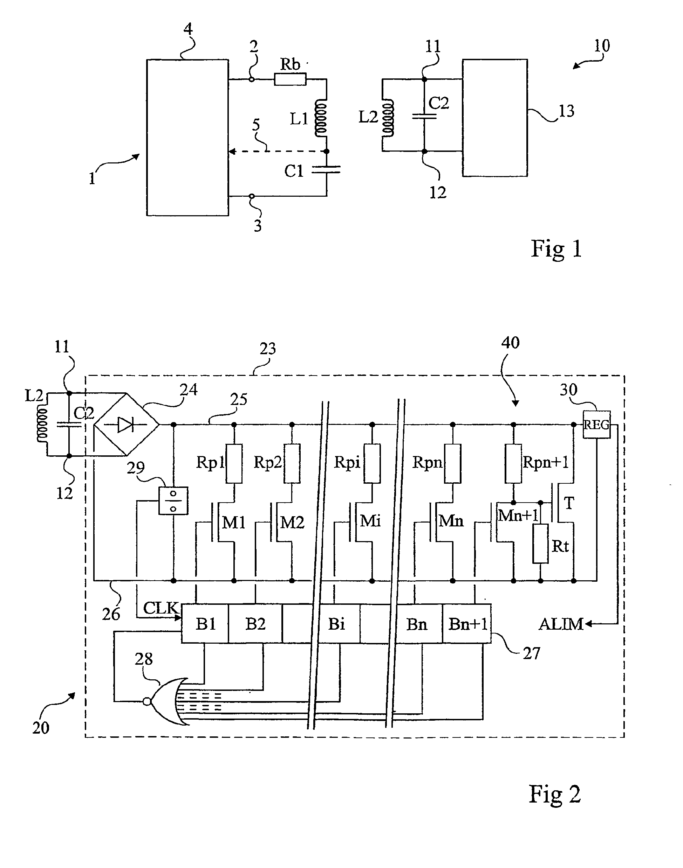

La figure 1 représente, de façon très schématique et simplifiée, un exemple classique de système d'échange de données entre une borne 1 de lecture-écriture et un transpondeur 10 du type auquel s'applique la présente invention.

Généralement, la borne 1 est essentiellement constituée d'un circuit oscillant série, formé d'une inductance L1, en série avec un condensateur C1 et une résistance Rb, entre une borne 2 de sortie d'un amplificateur ou coupleur d'antenne (non représenté) et une borne 3 de référence (généralement, la masse). Le coupleur d'antenne fait partie d'un circuit 4 de commande du circuit oscillant et d'exploitation des données reçues comprenant, entre autres, un modulateur/démodulateur et un microprocesseur de traitement des commandes et des données. Le circuit 4 de la borne communique généralement avec différents circuits d'entrée-sortie (clavier, écran, moyen d'échange avec un serveur, etc.) et/ou de traitement non représentés. Les circuits de la borne de lecture-écriture tirent l'énergie nécessaire à leur fonctionnement d'un circuit d'alimentation (non représenté) raccordé, par exemple, au réseau de distribution électrique.

Un transpondeur 10, destiné à coopérer avec une borne 1, comporte essentiellement un circuit oscillant parallèle formé d'une inductance L2, en parallèle avec un condensateur C2, entre deux bornes 11, 12 d'entrée d'un circuit 13 de commande et de traitement. Les bornes 11 et 12 sont, en pratique, reliées à l'entrée d'un moyen de redressement (non représenté en figure 1) dont les sorties constituent des bornes d'alimentation continue des circuits internes au transpondeur. Ces circuits comprennent généralement, essentiellement, un microprocesseur ou un circuit en logique câblée, une mémoire, un démodulateur des signaux éventuellement reçus de la borne 1, et un modulateur pour transmettre des informations à la borne. Par exemple, dans le cas d'une étiquette électronique auquel s'applique plus particulièrement la présente invention, ces informations sont le plus souvent constituées d'un code (binaire) permettant au système de traitement, côté borne 1, d'identifier le produit auquel est associée l'étiquette.

Le circuit oscillant de la borne 1 est excité par un signal haute fréquence (par exemple, 13,56 MHz) destiné à être capté par un transpondeur 10. Quand le transpondeur 10 se trouve dans le champ de la borne 1, une tension haute fréquence est engendrée aux bornes 11, 12 du circuit résonant du transpondeur. Cette tension, après redressement et écrêtement éventuel, est destinée à fournir la tension d'alimentation des circuits électroniques 13 du transpondeur.

Les circuits oscillants de la borne et du transpondeur sont généralement accordés sur une même fréquence correspondant à la fréquence du signal d'excitation du circuit oscillant de la borne 1. Ce signal haute fréquence (par exemple, 13,56 MHz) sert de porteuse de télé-alimentation à destination des transpondeurs se trouvant dans le champ de la borne et, le cas échéant de porteuse de transmission de données de la borne vers ce ou ces transpondeurs. Quand un transpondeur se trouve dans le champ d'une borne 1, une tension haute fréquence est engendrée aux bornes 11 et 12 du circuit résonnant du transpondeur. Cette tension, après redressement et écrêtement éventuel, fournit la tension d'alimentation des circuits électroniques 13 du transpondeur.

La porteuse haute fréquence émise par la borne est généralement modulée en amplitude par celle-ci selon différentes techniques de codage afin de transmettre des données et/ou des commandes à un ou plusieurs transpondeurs dans le champ. En retour, la transmission des données du transpondeur vers la borne s'effectue généralement en modulant la charge constituée par le circuit résonnant L2, C2. Cette variation de charge (appelée rétromodulation) s'effectue au rythme d'une sous-porteuse de fréquence (par exemple, 847,5 kHz) inférieure à celle de la porteuse. Cette variation de charge peut alors être détectée par la borne sous la forme d'une variation d'amplitude ou d'une variation de phase au moyen, par exemple, d'une mesure de la tension aux bornes du condensateur C1 ou du courant dans le circuit oscillant. En figure 1, le signal de mesure a été symbolisé par une liaison 5 en pointillés reliant le point milieu entre l'inductance L1 et le condensateur C1 au circuit 2.

La rétromodulation effectuée par le transpondeur peut être résistive ou capacitive. L'invention concerne un transpondeur à rétromodulation résistive. La rétromodulation résistive consiste à connecter, en parallèle sur le circuit résonnant L2, C2, une résistance en série avec un interrupteur (généralement un transistor MOS). On commande l'interrupteur en fonction du code à transmettre (0 ou 1) au rythme de la sous-porteuse. La connexion parallèle est généralement effectuée en aval du pont redresseur.

De plus en plus, on cherche à intégrer la totalité du transpondeur dans une même puce de silicium (antenne L2, condensateur C2 et circuit 13). De plus, on cherche à minimiser la surface de cette puce afin de miniaturiser les transpondeurs, en particulier dans des applications aux étiquettes électroniques. Une étiquette électronique peut alors remplacer l'impression d'un code à barres classique pour contenir l'identifiant d'un produit.

Un problème des transpondeurs classiques est lié au besoin d'utiliser un modulateur-démodulateur pour convertir un code (données numériques, code d'identification d'une étiquette, etc.) à transmettre vers la borne de lecture-écriture. Ce besoin entraîne le recours nécessaire à une mémoire de stockage (par exemple, une RAM, ROM, EPROM, ou EEPROM) du code sous forme binaire et à un circuit de modulation en amont des éléments de rétromodulation résistive proprement dits. Cette complexité nuit à la miniaturisation et au coût des transpondeurs actuels.

Un autre inconvénient est que la programmation d'un code binaire et, plus généralement, l'inscription de données dans un transpondeur électromagnétique, requiert au mieux une communication avec une borne de lecture-écriture et un protocole d'échange complexe. Au pire, dans le cas où l'on souhaiterait stocker un code immuable dans une mémoire à programmation unique, il est nécessaire d'inscrire ce code lors de la fabrication dans une EPROM ou une EEPROM.

Une autre technique connue est d'augmenter la valeur d'une résistance en la soumettant optiquement à un laser réduisant physiquement sa taille. Un inconvénient est le coût exorbitant de l'opération qui doit être répétée pour chaque puce. Un autre inconvénient est que la manipulation est visible optiquement, donc détectable.

Le document GB-A-2 279 474 décrit un dispositif de codage pour étiquette radiofréquence comportant un circuit oscillant parallèle propre à extraire un champ rayonné d'un signal d'alimentation.

Le document WO 97/05665 décrit un élément de mémoire constitué d'une résistance qui peut prendre une pluralité de valeurs de résistance à l'aide d'un courant de programmation.

Le document US 5 536 968 décrit un réseau de fusibles en silicium polycristallin.

La présente invention vise à pallier les inconvénients des transpondeurs classiques. En particulier, l'invention vise à proposer un transpondeur électromagnétique évitant le recours à un modulateur numérique pour transmettre des données stockées dans des éléments de mémorisation.

L'invention vise également à préserver la compatibilité du transpondeur avec les bornes de lecture-écriture existantes.

L'invention vise également à permettre une programmation simple d'un code binaire dans un transpondeur électromagnétique. En particulier, l'invention vise à éviter le recours à une communication bidirectionnelle pour inscrire un code dans un transpondeur.

Plus généralement, l'invention vise à permettre l'émission, par un transpondeur électromagnétique, d'un message quelconque sans qu'il soit nécessaire de recourir à un modulateur de données stockées dans une mémoire numérique.

L'invention vise également à rendre indécelable, hors fonctionnement, un code stocké dans un transpondeur électromagnétique.

L'invention vise également à permettre une programmation après fabrication du circuit intégré, alors que celui-ci est dans son environnement applicatif.

Pour atteindre ces objets et d'autres, la présente invention prévoit un transpondeur électromagnétique comprenant :

un circuit oscillant parallèle propre à extraire d'un champ rayonné un signal d'alimentation ;
en parallèle sur le circuit oscillant, plusieurs branches comprenant chacune une résistance programmable et un interrupteur ; et
un élément de commande cyclique de fermeture des interrupteurs successivement, chaque résistance constituant un élément de stockage d'une partie de code stocké dans le transpondeur.

Selon un mode de réalisation de la présente invention, les résistances sont en silicium polycristallin et sont dimensionnées pour avoir des valeurs nominales identiques.

Selon un mode de réalisation de la présente invention, la programmation d'une partie de code dans une résistance est commandée en forçant la circulation d'un courant dans la résistance en silicium polycristallin qui soit supérieur au courant pour lequel la valeur de cette résistance est maximum.

Selon un mode de réalisation de la présente invention, le courant de programmation est extrait d'un champ rayonné par une borne de lecture-écriture, d'une puissance supérieure à la puissance d'un champ rayonné de lecture.

Selon un mode de réalisation de la présente invention, l'élément de commande cyclique est constitué d'un registre à décalage commandé par un signal d'horloge, chaque interrupteur étant commandé par un bit du registre à décalage.

Selon un mode de réalisation de la présente invention, le signal d'horloge est extrait du champ rayonné par une borne de lecture-écriture.

Selon un mode de réalisation de la présente invention, une entrée d'initialisation du registre à décalage est reliée en sortie d'une porte logique de type NON-OU dont les entrées reçoivent, en parallèle, les bits du registre à décalage.

Selon un mode de réalisation de la présente invention, le transpondeur comporte un circuit de verrouillage du code stocké interdisant une deuxième programmation.

Selon un mode de réalisation de la présente invention, le circuit de verrouillage comporte un élément de limitation de la tension aux bornes desdites branches, la consigne de régulation étant fonction d'une résistance de stockage additionnelle en silicium polycristallin dont la valeur est diminuée en fin de programmation.

Selon un mode de réalisation de la présente invention, le transpondeur comporte un ensemble de branches de synchronisation constituées chacun d'une résistance de calage et d'un interrupteur de commande, lesdites branches de synchronisation étant commandées par ledit élément de commande cyclique.

Selon un mode de réalisation de la présente invention, les résistances programmables sont programmées à des valeurs choisies parmi plusieurs valeurs, de façon à stocker un code multi-niveaux.

Selon un mode de réalisation de la présente invention, tous ses constituants sont intégrés sur une même puce, dépourvue de plot d'entrée-sortie.

L'invention prévoit également un procédé de programmation d'un code dans un transpondeur, consistant à imposer temporairement et successivement, dans chacune des résistances dont on souhaite changer l'état par rapport à l'état non programmé, la circulation d'un courant de contrainte supérieur à un courant pour lequel la valeur de cette résistance présente un maximum.

Selon un mode de mise en oeuvre de la présente invention, le courant de contrainte est choisi dans une table prédéterminée de correspondance entre le courant de contrainte et la résistance finale souhaitée.

Selon un mode de mise en oeuvre de la présente invention, le courant de contrainte est choisi parmi plusieurs valeurs pour stocker un code multi-niveaux.

Ces objets, caractéristiques et avantages, ainsi que d'autres de la présente invention seront exposés en détail dans la description suivante de modes de mise en oeuvre et de réalisation particuliers faite à titre non limitatif en relation avec les figures jointes parmi lesquelles :

la figure 1 qui a été décrite précédemment représente, de façon très schématique, un exemple de système de communication à transpondeur électromagnétique du type auquel s'applique la présente invention ;

la figure 2 représente un mode de réalisation d'un transpondeur électromagnétique selon la présente invention ;

la figure 3 représente, par une vue partielle en perspective très schématique, un mode de réalisation d'une résistance en silicium polycristallin constitutive d'un élément de rétromodulation résistive d'un transpondeur selon la présente invention ; et

la figure 4 illustre, par un réseau de courbes, la stabilisation de la valeur d'un chemin électrique selon un mode de mise en oeuvre de la présente invention.

Les mêmes éléments ont été désignés par les mêmes références aux différentes figures. Pour des raisons de clarté, seuls les éléments qui sont nécessaires à la compréhension de l'invention ont été représentés aux figures et seront décrits par la suite. En particulier, les différents circuits de lecture et d'exploitation des données récupérées par une borne de lecture-écriture n'ont pas été détaillés. L'invention peut être mise en oeuvre quelle que soit l'exploitation faite de ces données.

Une caractéristique de la présente invention est d'utiliser, comme élément de mémorisation d'une donnée à transmettre, directement la valeur de résistance d'un élément de rétromodulation constitué d'un interrupteur en série avec une résistance. Ainsi, selon l'invention, on prévoit plusieurs éléments de rétromodulation en parallèle sur le circuit oscillant pour modifier sa charge. Une autre caractéristique de l'invention est que les résistances des différents éléments ont des valeurs différentes selon l'état (par exemple, 0 ou 1) de la partie de code qu'elles transmettent. L'invention utilise le fait que, en chargeant le circuit oscillant du transpondeur de façon différente, cette différence peut être interprétée par la borne comme signifiant un état différent du bit transmis par le transpondeur dans son champ.

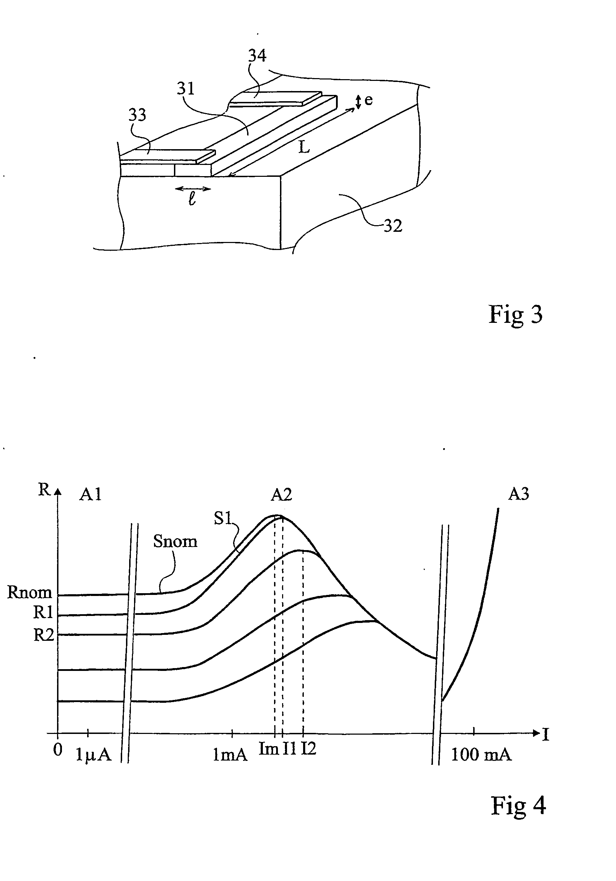

De préférence, les résistances des différentes branches de rétromodulation en parallèle sont toutes fabriquées de façon identique en silicium polycristallin et ont la même valeur nominale. La programmation s'effectue alors en provoquant une diminution, stable et irréversible, de la valeur de la résistance associée à la branche comme cela sera mieux compris en relation avec les figures 3 et 4.

La figure 2 représente un mode de réalisation d'un transpondeur électromagnétique 20 selon la présente invention.

Comme précédemment, le transpondeur 20 comporte un circuit oscillant parallèle formé d'une inductance L2, en parallèle avec un condensateur C2, entre deux bornes 11, 12 d'entrée d'un circuit 23 de commande et de traitement. Les bornes 11 et 12 sont reliées à l'entrée d'un pont de redressement 24 ou équivalent dont les sorties constituent des bornes 25, 26 d'alimentation continue des circuits internes au transpondeur.

Selon l'invention, le circuit 23 comporte, en parallèle entre les bornes 25 et 26 de sortie du pont 24, plusieurs (n) éléments de rétromodulation résistive constitués chacun d'une résistance Rpi (i étant compris entre 1 et n) et d'un interrupteur de commande Mi (par exemple, un transistor MOS). Chaque élément de rétromodulation est, selon l'invention, un élément de mémorisation d'une partie du code. En fait, on utilise la valeur de la résistance Rpi de chaque élément pour distinguer un état d'un autre pour la partie du code représentée par l'élément concerné. En variante, les éléments de rétromodulation sont connectés entre les bornes 11 et 12. Dans ce cas, chaque élément est associé à au moins une diode de redressement et la rétromodulation ne fonctionne, de préférence, qu'une alternance sur deux du signal d'excitation haute fréquence (par exemple, la porteuse de télé-alimentation à 13,56 MHz). Connecter les éléments de rétromodulation en aval du pont 24 présente toutefois l'avantage d'économiser de la place (moins de diodes).

Pour simplifier, on considérera le cas d'un code binaire, chaque élément représentant un bit du code. Toutefois, l'invention s'applique plus généralement à un codage multi-niveaux, voire analogique, dans la mesure où la moindre différence de valeur entre deux résistances de deux éléments de rétromodulation engendre une différence dans la charge représentée par le transpondeur sur le circuit oscillant d'une borne d'excitation et de lecture.

La commande des transistors Mi est effectuée en tout ou rien. Selon l'invention, cette commande s'effectue de façon successive pour chaque branche. De préférence, on prévoit une commande cyclique de façon que le code représenté par la suite de bits (dans le cas binaire) soit émis de façon répétitive, tant que le transpondeur est dans le champ d'une borne de lecture.

Selon le mode de réalisation préféré illustré par la figure 2, on utilise pour cela un registre à décalage 27 sur n bits Bi (autant que d'éléments de rétromodulation à commander), ou n+1 bits si un circuit de verrouillage 40 du code programmé est prévu. Les bits de sortie du registre à décalage sont prélevés en parallèle en direction des grilles de commande des transistors Mi. Ainsi, chaque bit du registre à décalage est fourni à un transistor Mi. Dans l'exemple représenté où les transistors Mi sont à canal N, le registre est à "1" circulant, c'est-à-dire qu'un seul bit du registre est à l'état haut (1), les autres bits étant à l'état bas (0) pour bloquer les n-1 transistors Mi restants. L'obtention du "1" circulant en entrée du registre vient, par exemple, d'une porte logique 28 de type NON-OU (NOR) recevant en entrées les n bits du registre à décalage pris en parallèle et dont la sortie fournit l'état du bit B1 au démarrage (initialisation). Comme on le verra par la suite, la porte 28 permet un démarrage automatique du registre dès qu'il est alimenté.

Selon un mode de réalisation préféré de l'invention, le séquencement du décalage du registre est fourni par un signal d'horloge CLK dérivant la fréquence d'horloge du signal d'excitation haute fréquence provenant de la borne. Pour ce faire, un diviseur de fréquence 29 est connecté entre les bornes 25 et 26 (en variante, entre les bornes 11 et 12), et sa sortie est reliée à l'entrée d'horloge du registre à décalage 27. Le taux de division du diviseur 29 dépend de la fréquence de la sous-porteuse de rétromodulation du système. Avec l'exemple d'une porteuse à 13,56 MHz et d'une sous-porteuse à 847,5 kHz, le taux de division est de 16.

L'alimentation du registre 27, de la porte 28 et du diviseur 29, provient d'un régulateur de tension 30 connecté entre les bornes 25 et 26 et dont la sortie fournit une tension d'alimentation ALIM continue et régulée de façon classique.

Le circuit 23 de la figure 2 comprend en outre, selon un mode de réalisation préféré, un circuit 40 de verrouillage du code programmé. Ce circuit comporte, dans le mode de réalisation illustré, un n+1 ème élément de rétromodulation constitué d'une résistance Rpn+1 et d'un transistor Mn+1. Le point milieu de l'association en série du transistor et de la résistance est connecté à la grille d'un transistor MOS T à canal N connecté entre les bornes 25 et 26, et par une résistance Rt, à la borne 26 (constituant dans cet exemple, la masse). La grille du transistor Mn+1 est reliée en sortie d'un n+1 ème bit du registre à décalage 27. Le fonctionnement du circuit 40 sera exposé par la suite, en relation avec le mode de réalisation préféré de programmation. Pour l'instant, on notera simplement que ce circuit 40 fonctionne, après programmation, comme un régulateur empêchant la tension entre les bornes 25 et 26 d'excéder une valeur susceptible d'engendrer une reprogrammation.

La lecture du code stocké dans un transpondeur conforme au mode de réalisation préféré de l'invention s'effectue de la façon suivante.

Au repos, tous les transistors Mi sont bloqués, le transpondeur n'étant pas alimenté (il ne dispose pas d'alimentation autonome). Dès que le transpondeur entre dans le champ d'une borne de lecture-écriture, il capte la porteuse de télé-alimentation. En effet, une borne d'un système à transpondeurs sans alimentation autonome émet en permanence pour "réveiller" les transpondeurs qui entrent dans son champ. Ainsi, dès que le transpondeur entre dans le champ, une tension apparaît entre les bornes 25 et 26. Le régulateur 30 produit alors une tension d'alimentation des différents éléments.

Dès que la tension d'alimentation fournie par le régulateur est suffisante pour que le registre à décalage 27 fonctionne (qu'il reçoit un signal d'horloge CLK du diviseur 29 et un état 1 de la porte 28), le transpondeur se met à émettre son code. En effet, comme initialement aucun bit du registre ne contient un état haut, la porte 28 fournit un état haut à l'entrée du registre 27. Le signal d'horloge provoque le stockage de cet état 1 dans le bit B1. Il en découle une fermeture de l'interrupteur M1, donc une rétromodulation avec la résistance R1. Selon la valeur de la résistance R1, le signal interprété par la borne fournit un 1 ou un 0. La transmission du premier bit est conditionnée par le signal CLK (ce qui correspond bien à la sous-porteuse de rétromodulation). A la période suivante de l'horloge CLK, le contenu du bit B1 est transféré au bit B2. Cela provoque l'ouverture du transistor M1 et la fermeture du transistor M2, et ainsi de suite. Le contenu du bit B1 est remplacé par l'état présent en sortie de la porte 28. Or, dès qu'un état 1 est présent dans le registre, donc dès que le premier bit B1 est chargé au démarrage, cette sortie bascule à l'état bas (0) et y reste jusqu'à l'extinction du système par disparition de l'alimentation, donc jusqu'à sortie du transpondeur hors du champ de la borne.

Tous les transistors Mi sont donc successivement commandés au rythme de l'horloge CLK, ce qui provoque l'émission, par rétromodulation de la porteuse de télé-alimentation, du code stocké par les résistances Rpi. De plus, l'émission du code est répétée cycliquement tant que le transpondeur reste alimenté par sa présence dans le champ de la borne. Même si transitoirement deux branches de rétromodulation sont actives lors du décalage du "1" circulant dans le registre, la durée de cette conduction simultanée de deux transistors Mi est négligeable devant la période de rétromodulation (par exemple, 847,5 kHz) et ne sera pas prise en compte par la borne comme une autre partie du code.

Un tel fonctionnement est particulièrement adapté aux étiquettes électromagnétiques ou analogues, pour lesquelles on souhaite qu'elles contiennent un code (généralement d'identification du produit qui les porte), et que ce code soit détecté par le passage du produit dans le champ d'une borne (portique de détection, caisse à lecture automatique, etc.).

Un avantage de la présente invention qui ressort déjà de la description qui précède est l'extrême simplicité du transpondeur. En particulier, un transpondeur selon l'invention comprend des composants simples et en faible nombre. Il n'est pas nécessaire d'avoir recours à une mémoire numérique imposant des circuits d'adressage et de lecture/écriture, ni à un modulateur/démodulateur pour fournir le code. De plus, un transpondeur selon l'invention peut se dispenser d'un microprocesseur. En outre, la réalisation des résistances en silicium polycristallin ne requiert aucune étape supplémentaire par rapport à celles requises pour la mise en oeuvre d'une technologie MOS dans laquelle peuvent être réalisés tous les composants (à l'exception de l'inductance L2). Toutefois, l'inductance est généralement intégrée sur la même puce. Le transpondeur de l'invention est donc particulièrement intéressant pour constituer une étiquette électronique.

La programmation d'un code dans un transpondeur selon l'invention s'effectue de la façon suivante. De préférence, toutes les résistances Rpi sont fabriquées de façon identique, de sorte qu'elles présentent toutes une même valeur nominale. Cette valeur nominale conditionne un état dit non programmé de l'élément de rétromodulation et correspond, pour un code binaire, à un des deux états (0 ou 1).

Une caractéristique de la présente invention est de prévoir une programmation d'un élément de rétromodulation vers un autre état que l'état non programmé en provoquant une diminution irréversible de la valeur de sa résistance Rpi. Pour cela, on impose la circulation d'un courant dans cette résistance qui soit supérieur au courant pour laquelle la valeur de la résistance présente un maximum. Cette caractéristique de l'invention sera mieux comprise par la suite en relation avec les figures 3 et 4. Pour l'instant, on se contentera de dire que, si on fait circuler, dans une résistance Rpi, un courant suffisant, on provoque une diminution irréversible de la valeur de cette résistance lorsqu'elle redevient traversée par un courant nominal (correspondant à la plage de courants de fonctionnement pour laquelle elle est conçue). Selon l'invention, le courant de programmation (de l'ordre d'un à dix milliampères) est au-delà de la plage de courants (jusqu'à cent microampères) de fonctionnement.

Selon un premier mode de réalisation, les bornes des résistances Rpi sont accessibles, de préférence par l'intermédiaire d'un sélecteur de type multiplexeur, depuis des bornes de la puce de circuit intégré. Dans ce cas, la programmation est effectuée en appliquant, aux bornes de chaque résistance dont on souhaite diminuer la valeur, une tension de programmation permettant la circulation du courant de programmation. On doit alors intégrer, dans le transpondeur, les quelques circuits (multiplexeur, etc.) nécessaires à la sélection des résistances individuellement. En variante, si le nombre d'éléments de rétromodulation n'est pas trop élevé, on peut prévoir des accès individuels par des plots aux bornes de chaque résistance. En présence du circuit de verrouillage 40, la résistance Rpn+1 est, en fin de programmation de toutes les autres résistances, programmée en diminution de sa valeur.

Selon un deuxième mode préféré de réalisation, la programmation du transpondeur s'effectue en radiofréquence. On utilise alors un émetteur, de type borne de lecture-écriture, dont la porteuse de télé-alimentation (par exemple, à 13,56 MHz) est modulée en puissance entre une première valeur insuffisante pour modifier la valeur des résistances et une deuxième valeur suffisante pour que le courant circulant dans une des résistances Rpi sélectionnées provoque la diminution de valeur de cette résistance. La première puissance est quand même suffisante pour alimenter le transpondeur et permettre le fonctionnement de ses constituants. La modulation de la puissance d'émission correspond au code binaire à stocker dans le transpondeur. De préférence, la modulation est effectuée au rythme de la fréquence de rétromodulation du transpondeur. Ainsi, il n'est pas nécessaire de commander indépendamment le passage d'un élément de rétromodulation au suivant, ce passage s'effectue automatiquement par le registre à décalage 27 du transpondeur.

Pour la mise en oeuvre du circuit 40 de verrouillage représenté en figure 2, la programmation doit commencer par la résistance Rp1 pour se terminer par la résistance Rpn+1. En effet, au départ, les résistances ont toutes leur valeur nominale, y compris la résistance Rpn+1 qui est aussi en silicium polycristallin. Cette résistance Rpn+1 est, en fabrication, dimensionnée pour que le transistor T limite la tension entre les bornes 25 et 26, à un niveau dit de programmation.

Tant que le transistor Mn+1 n'est pas rendu passant, la résistance Rt forme, avec la résistance Rpn+1, un diviseur de tension de commande du transistor T de limitation. La résistance Rt est cycliquement court-circuitée par le transistor Mn+1, ce qui entraîne le blocage du transistor T.

Pendant la programmation, on prévoit que la puissance d'émission de la borne est au niveau de programmation lorsqu'on arrive à la résistance Rpn+1. Il en découle une diminution de valeur de cette résistance qui modifie le rapport entre les résistances Rpn+1 et Rt. Les résistances Rpn+1 et Rt sont dimensionnées pour que, une fois que la valeur de la résistance Rpn+1 est diminuée, le transistor T limite la tension entre les bornes 25 et 26 à un niveau inférieur au niveau de programmation (le transistor T fonctionne de préférence en régime linéaire). Par conséquent, le transpondeur est protégé contre une reprogrammation, même s'il se trouve ensuite soumis à un champ accidentellement suffisant pour, en principe, engendrer une modification de valeur des résistances. Il n'est pas nécessaire que la tension à laquelle le transistor T limite la tension corresponde à la tension d'utilisation. Il suffit qu'il ne permette par d'atteindre la tension de programmation, c'est-à-dire, comme on le verra par la suite, une tension telle que le courant imposé aux résistances est supérieur à un courant pour lequel ces résistances présentent une valeur maximale.

La présence du circuit 40 entraîne que, en lecture, le code comporte un bit prédéterminé à la fin. Cela n'a toutefois rien de gênant.

Le circuit de décalage illustré par la figure 2 est compatible avec le respect des contraintes dues à la programmation en dernier lieu de la résistance Rpn+1. En effet, comme la porte 28 commande le registre pour qu'il démarre au bit B1 quand le transpondeur est alimenté, il suffit que l'on déclenche la mise en marche de l'émetteur (la borne) quand le transpondeur est dans le champ, c'est-à-dire à proximité. Cela ne constitue en pratique pas une contrainte car la programmation est une opération volontaire et particulière. On peut, par exemple, prévoir une borne spéciale avec un socle de réception du transpondeur (garantissant une proximité suffisante). On ne déclenche la borne (à la fois pour l'émission et la modulation de puissance) que quand le transpondeur à programmer est en place.

Un avantage de cette solution est que cela minimise le nombre de circuits du transpondeur. En effet, aucun autre circuit que ceux décrits en relation avec la figure 2 n'est nécessaire.

Pour la programmation des résistances de rétromodulation, on pourra dissocier plusieurs phases distinctes dans la vie du produit. Par exemple, on prévoit un premier groupe de branches de rétromodulation (première série de résistances) programmable à l'issue de la fabrication pour contenir un code "fabricant". Le reste des branches est laissé disponible pour être programmé (en une ou plusieurs fois) par l'utilisateur (final ou non).

Selon une variante de réalisation non représentée, on prévoit une synchronisation commandée du registre à décalage avec la borne. Par exemple, on peut prévoir que la borne émettra d'abord à faible puissance (puissance de lecture) et que le transpondeur comporte un certain nombre de résistances de calage dimensionnées en fabrication pour donner, par exemple, l'état inverse des résistances Rpi non programmées. En variante, les résistances de calage fournissent un code prédéterminé. En analysant la rétromodulation, la borne est alors en mesure de détecter la position de la première résistance programmable dans la lecture cyclique, afin de synchroniser le début de sa modulation de puissance. Les résistances de calage sont bien entendu également associées à un transistor de commande et à un bit du registre à décalage. Il en découle qu'elles interviennent également en lecture. On peut soit en tenir compte dans la construction des codes à stocker, soit, selon un mode de réalisation préféré, les prévoir en silicium polycristallin et les programmer vers des valeurs inférieures à la valeur programmée des résistances Rpi. Dans ce dernier cas, on obtient, en lecture, un code à trois niveaux, le niveau le plus bas correspondant aux résistances de calage. Cela permet une synchronisation également en lecture. Ce mode de réalisation reste compatible avec l'utilisation du circuit de verrouillage 40. En effet, bien que les résistances de calage soient placées dans le cycle, de préférence, avant les résistances Rpi, donc avant la résistance Rpi+1, on peut prévoir, avant de programmer la résistance Rpi+1, de refaire un cycle pour programmer les résistances de calage. Même si ce cycle est prévu après programmation des autres résistances Rpi, il suffit, quand on repasse dessus pour la seconde fois, de le faire à faible puissance, pour ne pas modifier le code programmé. Cela ne pose pas de problème en raison de la synchronisation.

La figure 3 représente un mode de réalisation d'une résistance en silicium polycristallin utilisée pour former les résistances Rpi des éléments de rétromodulation selon le mode de réalisation préféré de l'invention.

Une telle résistance (désignée par 31 en figure 2) est constituée d'une piste (dite aussi barreau) en silicium polycristallin obtenue par gravure d'une couche déposée sur un substrat 32 isolant. Le substrat 32 est indifféremment directement constitué du substrat du circuit intégré portant le transpondeur ou est constitué d'une couche isolante formant un substrat isolant ou équivalent pour la résistance 31. La résistance 31 est connectée, par ses deux extrémités, à des pistes conductrices (par exemple, métalliques) 33 et 34 destinées à raccorder le barreau résistif aux autres éléments du circuit intégré. La représentation schématique de la figure 3 ne fait pas référence aux différentes couches isolantes et conductrices constituant généralement le circuit intégré. Pour simplifier, on s'est contenté de représenter le barreau résistif 31 posé sur le substrat isolant 32 et en contact, par les extrémités de sa face supérieure, avec les deux pistes métalliques 33 et 34. En pratique, les liaisons de l'élément résistif 31 aux autres composants du circuit intégré sont obtenues par des pistes plus larges en silicium polycristallin partant des extrémités du barreau 31 dans l'alignement de celui-ci. En d'autres termes, l'élément résistif 31 est généralement formé en rendant un tronçon d'une piste en silicium polycristallin plus étroit que le reste de la piste.

La résistance R de l'élément 31 est donnée par la formule suivante :

$$R = \rho(L/s),$$

où p désigne la résistivité du matériau (silicium polycristallin le cas échéant dopé) constituant la piste dans laquelle est gravé l'élément 31, où L désigne la longueur de l'élément 31, et où s désigne sa section, c'est-à-dire sa largeur 1 par son épaisseur e. La résistivité p de l'élément 31 dépend, entre autres, du dopage éventuel du silicium polycristallin le constituant.

Le plus souvent, lors de la réalisation d'un circuit intégré, on prévoit les résistances en faisant référence à une notion dite de résistance par carreau $R_\square$ (square resistance). Cette résistance par carreau se définit comme étant la résistivité du matériau divisée par l'épaisseur avec laquelle il est déposé. En reprenant la relation ci-dessus donnant la résistance d'un élément 31, la résistance est donc donnée par la relation :

$$R = R_\square * L/l.$$

Le quotient L/1 correspond à ce que l'on appelle le nombre de carreaux (square number) constituant l'élément résistif 31. Cela représente, vu de dessus, le nombre de carreaux de dimension donnée fonction de la technologie, mis côte à côte pour former l'élément 31.

La valeur de la résistance en silicium polycristallin est donc définie, à la fabrication, d'après les paramètres ci-dessus, conduisant à des résistivités et résistances dites nominales. Généralement, l'épaisseur e du silicium polycristallin est fixée par d'autres paramètres de fabrication du circuit intégré. Par exemple, cette épaisseur est fixée par l'épaisseur souhaitée pour les grilles des transistors MOS du circuit intégré.

Une caractéristique de la présente invention est d'imposer temporairement, dans une résistance en silicium polycristallin (Rpi) dont on souhaite diminuer irréversiblement la valeur pour modifier le niveau de charge engendré sur le circuit oscillant du transpondeur et coder ainsi un état différent, un courant de programmation ou de contrainte supérieur à un courant pour lequel la résistance passe par une valeur maximale, ce courant étant au-delà de la plage de courants de fonctionnement normal (en rétromodulation) de cette résistance. En d'autres termes, on diminue la résistivité du silicium polycristallin dans la plage de courants de fonctionnement, de façon stable et irréversible, en imposant temporairement dans l'élément résistif correspondant la circulation d'un courant au-delà de la plage de courants de fonctionnement.

Une autre caractéristique de l'invention est que le courant servant à diminuer la valeur de la résistance est, à la différence d'un élément fusible, non destructif pour l'élément en silicium polycristallin.

La figure 4 illustre, par un réseau de courbes donnant la résistance d'un élément en silicium polycristallin du type de celui représenté en figure 3 en fonction du courant le traversant, un mode de mise en oeuvre de la présente invention pour stabiliser une cellule par diminution de la valeur d'une de ses résistances.

On suppose que le silicium polycristallin ayant servi à la fabrication de l'élément résistif 31 (Rpi) présente une résistivité nominale conférant à l'élément 31, pour les dimensions 1, L et e données, une valeur de résistance $R_{nom}$. Cette valeur nominale (d'origine) de la résistance correspond à la valeur prise de façon stable par l'élément résistif 31 dans la plage de courants de fonctionnement du système, c'est-à-dire généralement pour des courants inférieurs à 100 µA.

Selon l'invention, pour diminuer la valeur de la résistance et passer de façon irréversible et stable, par exemple, à une valeur R1 inférieure à $R_{nom}$, on impose dans l'élément résistif 31 un courant (par exemple I1), dit de contrainte, supérieur à un courant Im pour lequel la valeur de la résistance R de l'élément 31 est maximale sans toutefois être infinie. Comme l'illustre la figure 4, une fois que ce courant I1 a été appliqué à l'élément résistif 31, on obtient, dans la plage A1 de courants de fonctionnement du circuit intégré, une résistance stable de valeur R1. En fait, l'allure $S_{nom}$ de la résistance en fonction du courant est stable pour des courants relativement faibles (inférieurs à 100 µA). Cette allure se met à croître pour des courants sensiblement supérieurs de l'ordre de quelques milliampères, voire plus (plage A2). C'est dans cette plage de courants que l'allure Snom passe par un maximum pour la valeur Im. La résistance décroît ensuite progressivement. En figure 4, on a illustré une troisième plage A3 de courants correspondant à la plage généralement utilisée pour réaliser des fusibles. Il s'agit de courants de l'ordre du dixième d'ampère où la résistance se met à croître brusquement jusqu'à devenir infinie. Par conséquent, on peut considérer que l'invention utilise la plage intermédiaire A2 de courants entre la plage de fonctionnement A1 et la plage destructrice A3, pour diminuer de façon irréversible la valeur de la résistance ou plus précisément de la résistivité de l'élément en silicium polycristallin.

En effet, une fois passé le maximum de l'allure Snom de la résistivité en fonction du courant, la valeur prise par la résistance dans la plage de courants de fonctionnement se trouve inférieure à la valeur $R_{nom}$. La nouvelle valeur, par exemple R1, dépend de la valeur la plus élevée du courant (ici, I1) qui a été appliqué pendant la phase de diminution irréversible. On notera en effet que la diminution irréversible opérée par l'invention s'effectue dans une phase spécifique de personnalisation du transpondeur par inscription du code, hors du fonctionnement normal en lecture (plage A1) du circuit intégré, c'est-à-dire hors du fonctionnement normal de la résistance.

Théoriquement, une fois que la valeur de la résistance en silicium polycristallin a été abaissée vers une valeur inférieure (par exemple R1 en figure 4), on peut encore procéder à une diminution irréversible de cette valeur. Il suffit pour cela de dépasser le courant maximum I1 de la nouvelle allure S1 de la résistance en fonction du courant. Par exemple, on peut accroître la valeur du courant jusqu'à atteindre une valeur I2. Quand le courant est alors de nouveau diminué, on obtient une valeur R2 pour la résistance dans sa plage de fonctionnement normal. La valeur R2 est inférieure à la valeur R1 et, bien sûr, à la valeur $R_{nom}$. C'est pourquoi, dans l'application à un transpondeur électromagnétique tel que représenté en figure 2, il est préférable d'invalider la capacité du circuit d'éléments de rétromodulation d'effectuer une nouvelle programmation afin d'éviter une programmation accidentelle en présence d'un champ important.

On voit que toutes les allures de la résistance en fonction du courant se rejoignent sur la pente de décroissance de la valeur de la résistance, après être passé par le maximum de l'allure. Ainsi, pour un élément résistif donné (p, L, s), les courants I1, I2, etc. qui doivent être atteints, pour passer à une valeur de résistance inférieure, sont indépendants de la valeur de la résistance (Rnom, R1, R2) à partir de laquelle on provoque la diminution.

Ce qui a été exprimé ci-dessus comme valeur de résistance correspond en fait à une diminution de la résistivité du silicium polycristallin constituant l'élément résistif. Les inventeurs considèrent que l'on assiste à une modification stable de la structure cristalline du silicium polycristallin et que l'on assiste, en quelque sorte, à un fluage du matériau, la structure cristalline finale obtenue dépendant du courant maximum atteint.

Bien sûr, on veillera à ne pas dépasser la plage de courants de programmation A2 (de l'ordre de quelques milliampères) afin de ne pas risquer de détruire la résistance en silicium polycristallin. Cette précaution ne posera en pratique pas de problème dans la mesure où l'utilisation du silicium polycristallin pour constituer un fusible requiert des courants nettement plus élevés (de l'ordre du dixième d'ampère) qui ne sont pas disponibles une fois le circuit fabriqué.

La réalisation pratique d'une résistance en silicium polycristallin selon l'invention ne diffère pas de la réalisation d'une résistance classique. Partant d'un substrat isolant, on dépose une couche de silicium polycristallin que l'on grave en fonction des dimensions souhaitées pour la résistance. Comme l'épaisseur de silicium polycristallin déposée est généralement fixée par la technologie, les deux dimensions que l'on peut régler sont la largeur et la longueur. Généralement, on redépose un isolant sur le barreau de silicium polycristallin ainsi obtenu. Dans le cas d'une interconnexion en ligne, on aura modifié la largeur 1 par rapport aux pistes d'accès plus larges pour être fortement conductrices. Dans le cas d'un accès aux extrémités du barreau par le dessus comme cela est illustré en figure 3, on réalisera des vias dans l'isolant sur-jacent (non représenté) du barreau de silicium polycristallin pour connecter des pistes métalliques 33 et 34 de contact.

En pratique, pour disposer de la capacité de réglage de résistance la plus importante avec un courant de contrainte minimum, on cherchera à utiliser une épaisseur minimale et une largeur minimale pour les éléments résistifs. Dans ce cas, seule la longueur L conditionne la valeur nominale de la résistance une fois la structure du silicium polycristallin fixée. Le dopage éventuel du silicium polycristallin, quel que soit son type, n'entrave pas la mise en oeuvre de l'invention. La seule différence liée au dopage est la résistivité nominale avant contrainte et les résistivités obtenues pour des courants de contraintes donnés. En d'autres termes, pour un élément de dimensions données, cela conditionne le point de départ de la valeur de la résistance, et par voie de conséquence, les valeurs de résistance obtenues pour des courants de contrainte donnés.

Pour être en mesure d'appliquer les bonnes valeurs, on prédétermine, par exemple par mesures, les différents courants à appliquer pour passer des différentes valeurs de résistance à des valeurs inférieures. Par exemple, on utilise une résistance de test que l'on soumet à une augmentation par pallier du courant, en revenant après chaque augmentation dans la plage des courants de fonctionnement pour mesurer la valeur obtenue de résistance. Les valeurs mesurées vont suivre la courbe Snom. Par conséquent, on pourra déterminer les courants (I1, I2, figure 4) et les résistances associées (R1, R2). L'écart entre les valeurs de la table ainsi obtenue dépend du pas choisi pour l'augmentation par pallier du courant de contrainte. Cette prédétermination tient compte bien entendu de la nature du silicium polycristallin utilisé ainsi que préférentiellement de la résistance par carreau c'est-à-dire de la résistivité du matériau et de l'épaisseur dans laquelle il est déposé. En effet, comme les allures illustrées par la figure 4 peuvent également être lues comme allure de la résistance par carreau, on est en mesure de transposer les valeurs calculées aux différentes résistances d'un circuit intégré définies par les largeurs et longueurs des tronçons résistifs. On est alors en mesure de prédéterminer la valeur du courant de contrainte à appliquer à l'élément résistif pour diminuer, de façon irréversible et stable, sa valeur. Cette détermination permet de fixer le champ électromagnétique, donc la puissance d'émission, que doit fournir la borne de programmation dans le mode de réalisation préféré de programmation sans contact, par haute-fréquence. Dans le mode de réalisation simplifié où l'on prévoit un accès mécanique (plots) pour imposer une tension de programmation entre les bornes 25 et 26, cela permet de fixer la tension de programmation nécessaire. On notera qu'en raison de l'effet souhaité (diminution notable de la valeur de la résistance sélectionnée), la précision du courant de contrainte n'est pas critique pourvu d'être supérieur au courant maximum Im de la résistance. De préférence, on prendra en pratique une marge de sécurité confortable pour éviter que des variations d'écart du transpondeur dans le champ ou autres tolérances du circuit empêchent d'obtenir la diminution de valeur. Par exemple, on paramètrera le circuit en fonction d'un courant de contrainte donnant une valeur de résistance inférieure à la moitié de la valeur nominale.

Le changement de courbes, c'est-à-dire la diminution de la valeur de résistance en fonctionnement normal est quasi immédiate dès que le courant de contrainte correspondant est appliqué. Par quasi-immédiat, on entend une durée de quelques dizaines voir centaines de microsecondes qui suffisent pour appliquer la contrainte correspondante au barreau de silicium polycristallin et diminuer la valeur de sa résistance. Cette valeur empirique dépend de la taille (physique) du barreau. On pourra choisir une durée de quelques millisecondes par sécurité. De plus, on peut considérer que, une fois la durée minimale atteinte, toute durée supplémentaire d'application du courant de contrainte ne modifie pas, au moins au premier ordre, la résistance atteinte. En outre, même si compte tenu des mesures de prédétermination, on considère ne pas pouvoir négliger l'influence de la durée d'application de la contrainte, le mode préféré de mise en oeuvre (prédéterminer des valeurs de contraintes en durée et en intensité) est parfaitement compatible avec la prise en compte de la durée d'application de la contrainte.

A titre d'exemple particulier de mise en oeuvre, on a réalisé une résistance en silicium polycristallin dopée N+ ayant une section de 0,225 micromètre carré (1 = 0,9 $\mu$m, e = 0,25 $\mu$m) et une longueur L de 45 micromètres. Avec le silicium polycristallin utilisé et le dopage correspondant, la résistance nominale était d'environ 6300 Ohms. Cela correspond à une résistance par carreau d'environ 126 Ohms (50 carreaux). En appliquant à cette résistance un courant supérieur à trois milliampères, on a provoqué une diminution de sa valeur, stable pour un fonctionnement sous des courants allant jusqu'à 500 microampères. Avec un courant de 3,1 milliampères, la valeur de la résistance a été abaissée à environ 4500 Ohms. En appliquant à la résistance un courant de 4 milliampères, on a diminué la valeur de la résistance jusqu'environ 3000 Ohms. Les valeurs obtenues de résistances ont été les mêmes pour des durées de contraintes allant de 100 microsecondes à plus de 100 secondes.

Bien entendu, les exemples ci-dessus ainsi que les ordres de grandeurs donnés de courants et de résistances pour les différentes plages concernent les technologies actuelles. Les courants des plages A1, A2 et A3 pourront être différents (inférieurs) pour des technologies plus avancées et peuvent être transposés à des densités de courant. Le principe de l'invention n'en est pas modifié. On a toujours trois plages et on utilise la plage intermédiaire pour forcer la diminution de résistivité.

Dans un mode de réalisation simplifié, on se passera du circuit 40 de verrouillage. En effet, il y a en pratique peu de risques qu'un transpondeur soit soumis accidentellement aux puissances de programmation en raison de l'écart important entre les courants de programmation et de fonctionnement. Le circuit de verrouillage pourra donc être réservé à des applications plus sécuritaires où l'on craint une reprogrammation du code par un fraudeur.

Un avantage de la présente invention est qu'elle permet une programmation simple d'un transpondeur, compatible avec les structures des bornes classiques. Il suffit d'adapter leur programmation pour qu'elles fonctionnent avec un transpondeur de l'invention.

Un autre avantage de la présente invention est que le code contenu dans le transpondeur peut être programmé après fabrication.

Un avantage de la présente invention est qu'elle est compatible avec les technologies classiques de réalisation des transistors MOS.

Un autre avantage de l'invention est que le code stocké dans le transpondeur n'est pas détectable optiquement à la différence d'une résistance en silicium polycristallin qui serait utilisée comme fusible où la détérioration physique du barreau de silicium rend la programmation visible.

Un autre avantage de la présente invention est qu'avec des résistances fabriquées de façon identique, on empêche toute détection pirate du code hors des périodes où celui-ci est transmis.

Un autre avantage de la présente invention est qu'en permettant une programmation "sans contact" du transpondeur, on peut obtenir un transpondeur, réalisé sur une unique puce intégrant tous ses constituants, qui soit dépourvue de plot d'entrée-sortie.

On notera que l'invention est aisément transposable d'une technologie à une autre.

Bien entendu, la présente invention est susceptible de diverses variantes et modifications qui apparaîtront à l'homme de l'art. En particulier, les dimensionnements des résistances en silicium polycristallin en vue d'obtenir une valeur nominale dépendent de l'application et sont à la portée de l'homme du métier à partir des indications fonctionnelles données ci-dessus. De même, le choix du nombre de bits à stocker (donc du nombre d'éléments de rétromodulation) dans un transpondeur selon l'invention est fonction de sa destination. De plus, les valeurs des contraintes en tension ou en courant pour la mise en oeuvre de l'invention sont également à la portée de l'homme du métier.

En outre, bien que l'invention ait été décrite en relation avec une simplification extrême du transpondeur, le recours à plusieurs éléments de rétromodulation pour stocker directement un code dans un transpondeur peut être envisagé avec un microprocesseur de commande ou analogue. Par exemple, on peut prévoir de limiter le nombre de cycles de rétromodulation du code ou d'en commander le déclenchement/arrêt, notamment pour des questions d'anti-collision entre les codes de plusieurs transpondeurs. Un exemple d'application d'une telle variante est le comptage de produits (inventaires ou caisses de magasin automatisées).

Enfin, bien que l'invention ait été décrite en relation avec des transistors MOS à canal N, sa structure se transpose aisément à des transistors MOS à canal P. Il suffit d'adapter la commande de ces transistors, par exemple, en prévoyant un registre (27, figure 2) à 0 circulant.

**Revendications**

1. Transpondeur électromagnétique (20) comportant un circuit oscillant parallèle (L2, C2) propre à extraire d'un champ rayonné un signal d'alimentation, **caractérisé en ce qu'**il comporte :

en parallèle sur le circuit oscillant, plusieurs branches comprenant chacune une résistance programmable (Rpi) en silicium polycristallin et un interrupteur (Mi) ;
un élément (27) de commande cyclique de fermeture des interrupteurs successivement, chaque résistance constituant un élément de stockage d'une partie de code stocké dans le transpondeur ; et
la programmation d'une partie de code dans une résistance étant commandée en forçant la circulation d'un courant dans la résistance qui soit supérieur au courant pour lequel la valeur de cette résistance est maximum.

2. Transpondeur selon la revendication 1, **caractérisé en ce que** les résistances (Rpi) sont dimensionnées pour avoir des valeurs nominales identiques.

3. Transpondeur selon la revendication 1 ou 2, **caractérisé en ce que** le courant de programmation est extrait d'un champ rayonné par une borne de lecture-écriture, d'une puissance supérieure à la puissance d'un champ rayonné de lecture.

4. Transpondeur selon l'une quelconque des revendications 1 à 3, **caractérisé en ce que** l'élément de commande cyclique est constitué d'un registre à décalage (27) commandé par un signal d'horloge (CLK), chaque interrupteur (Mi) étant commandé par un bit du registre à décalage.

5. Transpondeur selon la revendication 4, **caractérisé en ce que** le signal d'horloge (CLK) est extrait du champ rayonné par une borne de lecture-écriture.

6. Transpondeur selon la revendication 4 ou 5, **caractérisé en ce qu'**une entrée d'initialisation du registre à décalage (27) est reliée en sortie d'une porte logique (28) de type NON-OU dont les entrées reçoivent, en parallèle, les bits du registre à décalage.

7. Transpondeur selon l'une quelconque des revendications 1 à 6, **caractérisé en ce qu'**il comporte un circuit (40) de verrouillage du code stocké interdisant une deuxième programmation.

8. Transpondeur selon la revendication 7, **caractérisé en ce que** le circuit de verrouillage (40) comporte un élément (T) de limitation de la tension aux bornes desdites branches, la consigne de régulation étant fonction d'une résistance de stockage additionnelle en silicium polycristallin dont la valeur est diminuée en fin de programmation.

9. Transpondeur selon l'une quelconque des revendications 1 à 8, **caractérisé en ce qu'**il comporte un ensemble de branches de synchronisation constituées chacun d'une résistance de calage et d'un interrupteur de commande, lesdites branches de synchronisation étant commandées par ledit élément de commande cyclique.

10. Transpondeur selon l'une quelconque des revendications 1 à 9, **caractérisé en ce que** les résistances programmables sont programmées à des valeurs choisies parmi plusieurs valeurs, de façon à stocker un code multi-niveaux.

11. Transpondeur selon l'une quelconque des revendications 1 à 10, **caractérisé en ce que** tous ses constituants sont intégrés sur une même puce, dépourvue de plot d'entrée-sortie.

12. Procédé de programmation d'un code dans un transpondeur selon l'une quelconque des revendications 1 à 11, **caractérisé en ce qu'**il consiste à imposer temporairement et successivement, dans chacune des résistances (Rpi) dont on souhaite changer l'état par rapport à l'état non programmé, la circulation d'un courant de contrainte supérieur à an courant pour lequel la valeur de cette résistance présente un maximum.

13. Procédé selon la revendication 12, **caractérisé en ce que** le courant de contrainte est choisi dans une table prédéterminée de correspondance entre le courant de contrainte et la résistance finale souhaitée.

14. Procédé selon la revendication 12 ou 13, **caractérisé en ce que** le courant de contrainte est choisi parmi plusieurs valeurs pour stocker un code multi-niveaux.

**Claims**

1. An electromagnetic transponder (20) including:

a parallel oscillating circuit (L2, C2) adapted to extracting a supply signal from a radiated field; **characterized in that** it comprises
in parallel with the oscillating circuit, several branches each including a polysilicon programmable resistor (Rpi) and a switch (Mi);
a cyclic control element (27) for successively turning on the switches, each resistor forming an element for storing a portion of the code stored in the transponder; and

the programming of a code portion in a resistor being controlled by forcing a current in the resistor which is greater than the current for which the resistance of this resistor is maximum.

2. The transponder of claim 1, **characterized in that** the resistors (Rpi) are sized to have identical nominal values.

3. The transponder of claim 1 or 2, **characterized in that** the programming current is extracted from a field radiated by a read-write terminal, of a power greater than the power of a read radiated field.

4. The transponder of any of claims 1 to 3, **characterized in that** the cyclic control element is formed of a shift register (27) controlled by a clock signal (CLK), each switch (Mi) being controlled by a bit of the shift register.

5. The transponder of claim 4, **characterized in that** the clock signal (CLK) is extracted from the field radiated by a read-write terminal.

6. The transponder of claim 4 or 5, **characterized in that** a set input of the shift register (27) is connected with the output of a NOR-type logic gate (28) having its inputs receiving, in parallel, the bits of the shift register.

7. The transponder of any of claims 1 to 6, **characterized in that** it includes a circuit (40) for locking the stored code forbidding a second programming.

8. The transponder of claim 7, **characterized in that** the locking circuit (40) includes an element (T) for limiting the voltage across said branches, the regulation set point being a function of an additional polysilicon storage resistor, the value of which is decreased at the end of the programming .

9. The transponder of any of claims 1 to 8, **characterized in that** it includes an assembly of synchronization branches each comprising a setting resistor and a control switch, said synchronization branches being controlled by said cyclic control element.

10. The transponder of any of claims 1 to 9, **characterized in that** the programmable resistances are programmed at values selected from among several values, to store a multiple-level code.

11. The transponder of any of claims 1 to 10, **characterized in that** all its components are integrated on a same chip, having no input-output pad.

12. A method for programming a code in a transponder according to any of claims 1 to 11, **characterized in that** it consists of temporarily and successively drawing, in each of the resistors (Rpi) of which the state is desired to be changed with respect to the unprogrammed state, a constraint current greater than a current for which the value of this resistance exhibits a maximum.

13. The method of claim 12, **characterized in that** the constraint current is selected from a predetermined table mapping the constraint current and the desired final resistance.

14. The method of claim 12 or 13, **characterized in that** the constraint current is selected from among several values to store a multiple-level code.

**Patentansprüche**

1. Elektromagnetischer Transponder (20), der eine parallele Oszillationsschaltung (L2, C2) aufweist, die geeignet ist, um aus einem abgestrahlten Feld ein Versorgungssignal herauszuziehen;

   **dadurch gekennzeichnet, dass** er Folgendes aufweist:

   parallel zur Oszillationsschaltung mehrere Zweige, die jeder einen programmierbaren Widerstand (Rpi) aus polykristallinem Silizium und einen Schalter (Mi) aufweist;
   ein Zyklussteuerelement (27), um die Schalter aufeinander folgend auszuschalten, wobei jeder Widerstand ein Element zum Speichern eines Codeteils bildet, der in dem Transponder gespeichert ist; und
   wobei die Programmierung eines Teils des Codes in einem Widerstand **dadurch** gesteuert wird, dass die Zirkulation eines Stroms im Widerstand angewiesen wird, der größer als der Strom ist, für den der Wert dieses Widerstands maximal ist.

2. Transponder nach Anspruch 1, **dadurch gekennzeichnet, dass** die Widerstände (Rpi) so bemessen sind, dass sie identische Nennwerte haben.

3. Transponder nach Anspruch 1 oder 2, **dadurch gekennzeichnet, dass** der Programmierungsstrom aus einem Feld herausgezogen wird, welches von einem Lese-Schreibe-Terminal abgestrahlt wird, und zwar von größerer Stärke als die Stärke eines beim Lesen abgestrahlten Feldes.

4. Transponder nach einem der Ansprüche 1 bis 3, **dadurch gekennzeichnet, dass** das Zyklussteuerelement aus einem Schieberegister (27) gebildet wird, welches durch ein Taktsignal (CLK) gesteuert wird, wobei jeder Schalter (Mi) durch ein Bit des Schieberegisters gesteuert wird.

5. Transponder nach Anspruch 4, **dadurch gekennzeichnet, dass** das Taktsignal (CLK) aus dem Strahlungsfeld herausgezogen wird, welches von einem Lese-Schreibe-Terminal abgestrahlt wird.

6. Transponder nach Anspruch 4 oder 5, **dadurch gekennzeichnet, dass** ein Initialisierungseingang des Schieberegisters (27) mit dem Ausgang eines NOR-Logikgatters (28) verbunden ist, dessen Eingänge parallel die Bits des Schieberegisters aufnehmen.

7. Transponder nach einem der Ansprüche 1 bis 6, **dadurch gekennzeichnet, dass** er eine Schaltung (40) zum Verriegeln des gespeicherten Codes aufweist, die eine zweite Programmierung verbietet.

8. Transponder nach Anspruch 7, **dadurch gekennzeichnet, dass** die Verriegelungsschaltung (40) ein Element (T) zur Beschränkung der Spannung an den Anschlüssen der erwähnten Zweige aufweist, wobei der Einstell- bzw. Regelungspunkt eine Funktion eines zusätzlichen Speicherwiderstandes aus polykristallinem Silizium ist, dessen Wert am Ende der Programmierung verringert wird.

9. Transponder nach einem der Ansprüche 1 bis 8, **dadurch gekennzeichnet, dass** er eine Anordnung von Synchronisationszweigen aufweist, die jeder aus einem einstellbaren Widerstand und einem Steuerschalter bestehen, wobei die Synchronisationszweige durch das Zyklussteuerelement gesteuert sind.

10. Transponder nach einem der Ansprüche 1 bis 9, **dadurch gekennzeichnet, dass** die programmierbaren Widerstände auf Werte programmiert sind, die unter verschiedenen Werten ausgewählt wurden, um einen Multi-Level-Code bzw. Code mit mehreren Niveaus zu speichern.

11. Transponder nach einem der Ansprüche 1 bis 10, **dadurch gekennzeichnet, dass** alle seine Bestandteile auf dem gleichen Chip integriert sind, der kein Eingabe-Ausgabe-Glied bzw. Pad hat.

12. Verfahren zum Programmieren eines Codes in einen Transponder nach einem der Ansprüche 1 bis 11, **dadurch gekennzeichnet, dass** es aufweist, temporär und aufeinander folgend in jeden der Widerstände (Rpi), dessen Zustand im Verhältnis zum unprogrammierten Zustand verändert werden soll, einen Begrenzungsstrom zu ziehen, der größer ist als ein Strom, für den der Wert dieses Widerstandes ein Maximum zeigt.

13. Verfahren nach Anspruch 12, **dadurch gekennzeichnet, dass** der Begrenzungsstrom aus einer vorbestimmten Tabelle bzw. einem Kennfeld des Verhältnisses zwischen dem Begrenzungsstrom und dem erwünschten Endwiderstand ausgewählt wird.

14. Verfahren nach Anspruch 12 oder 13, **dadurch gekennzeichnet, dass** der Begrenzungsstrom aus mehreren Werten ausgewählt wird, um einen Multi-Level-Code zu speichern.

Fig 1

Fig 2

Fig 3

Fig 4

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- GB 2279474 A
- WO 9705665 A
- US 5536968 A